# EUROPEAN PATENT APPLICATION

(11) **EP 4 739 085 A2**
(43) Date of publication of application: **06.05.2026**
(21) Application number: 25210326.2
(22) Date of filing: 22.10.2025
(51) Int. Cl.: H10W 90/20, H10W 40/22

(54) **SYSTEMS AND METHODS OF THERMAL DISSIPATION VIAS FOR STACKED MEMORY MODULES**

(30) Priority: 29.10.2024 US 202463713557 P; 11.04.2025 US 202519177499
(71) Applicant: Samsung Electronics Co., Ltd., Suwon-si, Gyeonggi-do 16677 (KR)
(72) Inventor: JEONG, Hyoun Kwon, San Jose, CA, 95134 (US)
(74) Representative: Kuhnen & Wacker Patent- und Rechtsanwaltsbüro PartG mbB

(57) **Abstract**

Provided are systems, methods, and apparatuses for thermal dissipation vias for stacked memory modules (e.g., HBM modules). In one or more examples, the systems, devices, and methods include routing, for heat dissipation, a first through-silicon via, TSV, (555-a) vertically between a first stack of memory (515-a) and a second stack of memory (515-b); routing, for heat dissipation, a second TSV (555-b) horizontally between at least one of: a physical layer, PHY, of the first stack of memory (515-a) and a first memory die of the first stack of memory (515-a), or a PHY of the second stack of memory (515-b) and a first memory die of the second stack of memory (515-b).

## Description

### TECHNICAL FIELD

The disclosure relates generally to memory systems, and more particularly to thermal dissipation vias for stacked memory modules.

### BACKGROUND

The present background section is intended to provide context only, and the disclosure of any concept in this section does not constitute an admission that said concept is prior art.

Memory management is a form of resource management applied to computer memory. Some aspects of memory management provide dynamical allocation of portions of memory to programs at their request, and free the allocations for reuse when the portions of memory are no longer needed. Memory management provides important functionality for computer systems. However, improvements in memory management can be made with regards to high-performance computing and artificial intelligence (AI) systems. The disclosure relates generally to memory systems, and more particularly to thermal dissipation vias for stacked memory modules.

### SUMMARY

In various embodiments, the systems and methods described herein include systems, methods, and apparatuses for thermal dissipation vias for stacked memory modules. In some aspects, the techniques described herein relate to a device including: a first through-silicon via (TSV) for heat dissipation routed vertically adjacent to at least one of a first stack of memory or a second stack of memory; and a second TSV for heat dissipation routed horizontally between at least one of: a physical layer (PHY) of the first stack of memory and a first memory die of the first stack of memory, or a PHY of the second stack of memory and a first memory die of the second stack of memory.

In some aspects, the techniques described herein relate to a device, further including a third TSV routed horizontally between at least one of: the first memory die of the first stack of memory and a second memory die of the first stack of memory, or the first memory die of the second stack of memory and a second memory die of the second stack of memory.

In some aspects, the techniques described herein relate to a device, wherein the first TSV connects to a first metal layer positioned above the first stack of memory and the second stack of memory.

In some aspects, the techniques described herein relate to a device, wherein a heat sink is positioned on a top surface of the first metal layer.

In some aspects, the techniques described herein relate to a device, wherein the first TSV connects to a second metal layer below the first stack of memory and the second stack of memory.

In some aspects, the techniques described herein relate to a device, wherein the second metal layer is below at least one of the PHY of the first stack of memory or the PHY of the second stack of memory.

In some aspects, the techniques described herein relate to a device, wherein the second TSV connects to at least one of a first metal sidewall adjacent to an outer surface of the first stack of memory or a second metal sidewall adjacent to an outer surface of the second stack of memory.

In some aspects, the techniques described herein relate to a device, wherein the first TSV is routed between an inner surface of the first stack of memory and an inner surface of the second stack of memory.

In some aspects, the techniques described herein relate to a device, wherein at least one of the first TSV or the second TSV is routed through a semiconductor that is deposited over at least one of the first stack of memory or the second stack of memory.

In some aspects, the techniques described herein relate to a device, wherein the second TSV connects to the first TSV.

In some aspects, the techniques described herein relate to a stacked integrated circuit (IC) device including: a first through-silicon via (TSV) for heat dissipation routed vertically adjacent to at least one of a first stack of dies or a second stack of dies; and a second TSV for heat dissipation routed horizontally between at least one of: a physical layer (PHY) of the first stack of dies and a first IC die of the first stack of dies, or a PHY of the second stack of dies and a first IC die of the second stack of dies.

In some aspects, the techniques described herein relate to a stacked IC device, further including a third TSV routed horizontally between at least one of: the first IC die of the first stack of dies and a second IC die of the first stack of dies, or the first IC die of the second stack of dies and a second IC die of the second stack of dies.

In some aspects, the techniques described herein relate to a stacked IC device, wherein the first TSV connects to a first metal layer positioned above the first stack of dies and the second stack of dies.

In some aspects, the techniques described herein relate to a stacked IC device, wherein a heat sink is positioned on a top surface of the first metal layer.

In some aspects, the techniques described herein relate to a stacked IC device, wherein the first TSV connects to a second metal layer below the first stack of dies and the second stack of dies.

In some aspects, the techniques described herein relate to a stacked IC device, wherein the second metal layer is below at least one of the PHY of the first stack of dies or the PHY of the second stack of dies.

In some aspects, the techniques described herein relate to a stacked IC device, wherein the second TSV connects to at least one of a first metal sidewall adjacent to an outer surface of the first stack of dies or a second metal sidewall adjacent to an outer surface of the second stack of dies.

In some aspects, the techniques described herein relate to a method of thermal dissipation, the method including: routing, for heat dissipation, a first through-silicon via (TSV) vertically adjacent to at least one of a first stack of memory or a second stack of memory; and routing, for heat dissipation, a second TSV horizontally between at least one of: a physical layer (PHY) of the first stack of memory and a first memory die of the first stack of memory, or a PHY of the second stack of memory and a first memory die of the second stack of memory.

In some aspects, the techniques described herein relate to a method, further including routing a third TSV horizontally between at least one of: the first memory die of the first stack of memory and a second memory die of the first stack of memory, or the first memory die of the second stack of memory and a second memory die of the second stack of memory.

In some aspects, the techniques described herein relate to a method, wherein the first TSV connects to a first metal layer positioned above the first stack of memory and the second stack of memory.

A computer-readable medium is disclosed. The computer-readable medium can store instructions that, when executed by a computer, cause the computer to perform substantially the same or similar operations as described herein are further disclosed. Similarly, non-transitory computer-readable media, devices, and systems for performing substantially the same or similar operations as described herein are further disclosed.

The systems and methods described herein include multiple advantages and benefits. For example, implementing thermal through-silicon vias (TSVs) for semiconductor chip 3D stacking (e.g., high-bandwidth memory (HBM) 3D stacking) may increase thermal dissipation in a given compute node. In some cases, thermal TSVs may be implemented for any 3D stacking package that uses TSVs, increasing the rate of thermal dissipation for compute nodes that implement one or more types of 3D stacking packages. In some embodiments, thermal TSVs may be routed vertically between stacked dies (e.g., between HBM modules) and/or routed laterally between the dies of a die stack (e.g., between memory dies of at least one HBM module), which can further increase the rate of thermal dissipation in a given system.

### BRIEF DESCRIPTION OF THE DRAWINGS

The above-mentioned aspects and other aspects of the present systems and methods will be better understood when the present application is read in view of the following figures in which like numbers indicate similar or identical elements. Further, the drawings provided herein are for purpose of illustrating certain embodiments only; other embodiments, which may not be explicitly illustrated, are not excluded from the scope of this disclosure.

These and other features and advantages of the present disclosure will be appreciated and understood with reference to the specification, claims, and appended drawings wherein:
FIG. 1 illustrates an example system in accordance with one or more implementations as described herein.
FIG. 2 illustrates details of the system of FIG. 1, according to one or more implementations as described herein.
FIG. 3 illustrates an example system in accordance with one or more implementations as described herein.
FIG. 4 illustrates an example system in accordance with one or more implementations as described herein.
FIG. 5 illustrates an example system in accordance with one or more implementations as described herein.
FIG. 6 depicts a flow diagram illustrating an example method associated with the disclosed systems, in accordance with example implementations described herein.
FIG. 7 depicts a flow diagram illustrating an example method associated with the disclosed systems, in accordance with example implementations described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the spirit and scope of the present systems and methods as defined by the appended claims.

### DETAILED DESCRIPTION OF VARIOUS EMBODIMENTS

The details of one or more embodiments of the subject matter described herein are set forth in the accompanying drawings and the description below. Other features, aspects, and advantages of the subject matter will become apparent from the description, the drawings, and the claims.

Various embodiments of the present disclosure now will be described more fully hereinafter with reference to the accompanying drawings, in which some, but not all embodiments are shown. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media include all computer-readable media (including volatile and non-volatile media).

In one embodiment, a non-volatile computer-readable storage medium may include a floppy disk, flexible disk, hard disk, solid-state storage (SSS) (for example a solid-state drive (SSD)), solid state card (SSC), solid state module (SSM), enterprise flash drive, magnetic tape, or any other non-transitory magnetic medium, and/or the like. A non-volatile computer-readable storage medium may include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may include read-only memory (ROM), programmable read-only memory (PROM), erasable programmable read-only memory (EPROM), electrically erasable programmable read-only memory (EEPROM), flash memory (for example Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may include conductive-bridging random-access memory (CBRAM), phase-change random-access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random-access memory (FJG RAM), Millipede memory, racetrack memory, and/or the like.

In one embodiment, a volatile computer-readable storage medium may include random-access memory (RAM), dynamic random-access memory (DRAM), static random-access memory (SRAM), fast page mode dynamic random-access memory (FPM DRAM), extended data-out dynamic random-access memory (EDO DRAM), synchronous dynamic random-access memory (SDRAM), double data rate synchronous dynamic random-access memory (DDR SDRAM), double data rate type two synchronous dynamic random-access memory (DDR2 SDRAM), double data rate type three synchronous dynamic random-access memory (DDR3 SDRAM), Rambus dynamic random-access memory (RDRAM), Twin Transistor RAM (TTRAM), Thyristor RAM (T-RAM), Zero-capacitor (Z-RAM), Rambus in-line memory component (RIMM), dual in-line memory component (DIMM), single in-line memory component (SIMM), video random-access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present disclosure may be implemented as methods, apparatus, systems, computing devices, computing entities, and/or the like. As such, embodiments of the present disclosure may take the form of an apparatus, system, computing device, computing entity, and/or the like executing instructions stored on a computer-readable storage medium to perform certain steps or operations. Thus, embodiments of the present disclosure may take the form of a hardware embodiment, a computer program product embodiment, and/or an embodiment that comprises a combination of computer program products and hardware performing certain steps or operations.

Embodiments of the present disclosure are described below with reference to block diagrams and flowchart illustrations. Thus, it should be understood that each block of the block diagrams and flowchart illustrations may be implemented in the form of a computer program product, a hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some example embodiments, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The provided description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Data processing may include data buffering, aligning incoming data from multiple communication lanes, forward error correction (FEC), etc. For example, data may be received by an analog front end (AFE), which can prepare the incoming data for digital processing. The digital portion of the transceivers (e.g., digital signal processor (DSP)) may provide skew management, equalization, reflection cancellation, and/or other functions. It is to be appreciated that the process described herein can provide many benefits, including saving both power and cost.

Moreover, the terms "system", "component," "module", "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, SoC, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

The systems and methods described herein may be based on and/or may include a System-on-Chip (SoC). An SoC may include a microchip that contains electronic circuits and parts for independent operation. An SoC may be a type of integrated circuit (IC) design that combines many or all high-level function elements of an electronic device onto a single chip. SoCs can include a processor, memory, storage, input/output interfaces, including network interfaces, etc.

The systems and methods described herein may be based on and/or may include a system in a package (SiP). A SiP may include a number of integrated circuits (ICs) enclosed in one chip carrier package or encompassing an IC package substrate and may perform all or most of the functions of an electronic system. The ICs may be stacked using package on package, placed side by side, and/or embedded in the substrate. In SiPs, two or more dies may be stacked vertically on the package substrate. Stacked chips may be internally connected by fine wires that are bonded to the package substrate. In some cases, chips may be stacked based on through-silicon via (TSV) bonding. TSV can include a packaging technology that uses vertical electrical connections between silicon wafers or dies to replace the conventional wires used to connect chips. TSVs can be used to create 2.5D and/or 3D packages that contain multiple semiconductor dies. Additionally, or alternatively, solder bumps (e.g., based on flip chip technology) may be used to join stacked chips together and to the package substrate, or even multiple techniques may be used in a single package (e.g., solder bumps, TSV, bonded fine wires, etc.). Thus, while an SoC may integrate two or more ICs onto a single chip, a SiP may integrate two or more ICs in a single package.

A physical layer interface (PHY) can include electronic circuitry of a data communication interface that manages the physical transmission and reception of data over a communication medium like a cable, translating digital data into electrical signals that can be sent across the network. A PHY can be the lowest layer in the open systems interconnection (OSI) model.

The systems and methods described herein may be based on and/or may include high bandwidth memory (HBM). HBM can include a type of memory architecture used in high-performance computing applications that requires fast data transfer speeds. HBM may use stacking technology (e.g., 2.5D and/or 3D stacking technology) to pack more memory chips into a smaller space, which reduces the distance data needs to travel between the processor and memory. This results in higher bandwidth, which allows for faster data transfer, and lower power consumption, which can help extend battery life.

The systems and methods described herein may be based on and/or may include a die-to-die (D2D) interface. D2D may provide interconnectivity based on 3D-stacking, 2.5D packaging, etc. A D2D interface can include a functional block that allows for a data link between two semiconductor dies that are assembled in the same package. D2D interfaces can be used in applications such as networking, high-performance computing (HPC), hyperscale data center, and AI systems. D2D interfaces can provide high-speed, low-latency communication between two dies.

The systems and methods described herein may be based on and/or may include universal chiplet interconnect express (UCIe). UCIe may include die-to-die connectivity in multi-die systems. UCIe may define the physical layer, protocol stack, software model, and procedures for die-to-die interconnections. The protocol layer of UCIe may be based on compute express link (CXL) technologies (e.g., CXL.io (PCIe), CXL.mem and CXL.cache protocols). UCIe can enable low-latency, power-efficient D2D connectivity. UCIe can provide seamless interoperability (e.g., plug and play interoperability) similar to PCIe, universal serial bus (USB), etc.

A downside of stacking memory technology (e.g., 3D HBM technology) can include thermal issues (e.g., limited thermal dissipation). In some systems, cooling an HBM 3D PHY (e.g., PHY of a 3D stack of memory) can present a significant challenge based on 3D PHYs being placed underneath stacks of memory (e.g., HBM stacks). Overheating can lead to performance degradation, system instability, and potential system damage and/or data loss if thermal dissipation is not properly managed.

The systems and methods described herein improve the cooling of computer systems. The systems and methods described provide thermal dissipation based on through-silicon vias (TSVs) for stacked memory modules (e.g., 3D stacked HBM, stacked processing in memory modules). Also, the systems and methods described herein provide cooling for a base layer of a stacked memory module and/or intermediate layers stacked within the memory module. For example, the systems and methods described herein provide cooling for components of a base layer. The components of the base layer can include one or more PHYs, which can include at least one HBM 3D PHY. In some cases, the components of the base layer can include compute resources (e.g., compute die, one or more processor elements, processor units, etc.).

The cooling systems and methods described herein prevent thermal throttling and overheating, which could otherwise damage components and shorten the lifespan of a given system. In some cases, the cooling systems and methods described herein ensure computer components operate within safe temperature limits, allowing for stable and consistent performance, especially during demanding tasks like high-performance computing, artificial intelligence (AI) applications, etc. Also, the cooling systems and methods described herein improve performance, stability, and reliability of computer systems, such as high-performance computing (HPC) systems, hyperscale data centers, AI systems, etc. In addition, the cooling systems and methods described herein reduce energy consumption, lower operational costs, and optimize hardware utilization with efficient cooling solutions. Accordingly, the systems and methods described herein improve thermal dissipation in computer systems, which helps maintain optimal performance by preventing overheating of components like processors, memory, storage, etc.

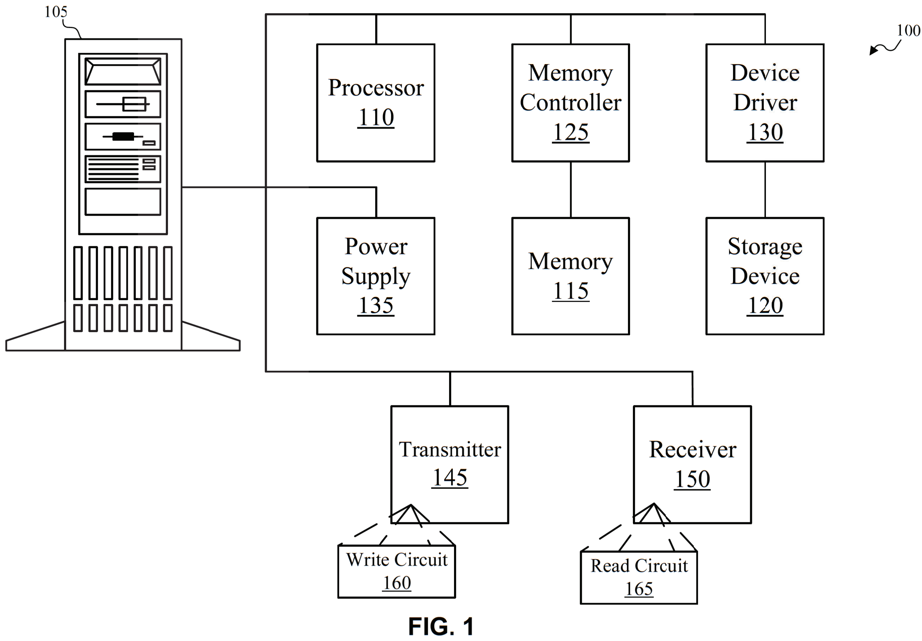

**FIG. 1** illustrates an example system 100 in accordance with one or more implementations as described herein. In FIG. 1, machine 105, which may be termed a host, a system, or a server, is shown. While FIG. 1 depicts machine 105 as a tower computer, embodiments of the disclosure may extend to any form factor or type of machine. For example, machine 105 may be a rack server, a blade server, a desktop computer, a tower computer, a mini tower computer, a desktop server, a laptop computer, a notebook computer, a tablet computer, etc.

Machine 105 may include processor 110, memory 115, and storage device 120. Processor 110 may be any variety of processor. It is noted that processor 110, along with the other components discussed below, are shown outside the machine for ease of illustration: embodiments of the disclosure may include these components within the machine. While FIG. 1 shows a single processor 110, machine 105 may include any number of processors, each of which may be single core or multi-core processors, each of which may implement a reduced instruction set computer (RISC) architecture or a complex instruction set computer (CISC) architecture (among other possibilities), and may be mixed in any desired combination.

Processor 110 may be coupled to memory 115. Memory 115 may be any variety of memory, such as flash memory, DRAM, SRAM, persistent RAM, ferroelectric RAM (FRAM), or NVRAM, such as MRAM, phase change memory (PCM), or resistive random-access memory (ReRAM). Memory 115 may include volatile and/or non-volatile memory. Memory 115 may use any desired form factor: for example, SIMM, DIMM, non-volatile DIMM (NVDIMM), etc. Memory 115 may be any desired combination of different memory types, and may be managed by memory controller 125. Memory 115 may be used to store data that may be termed "short-term": that is, data not expected to be stored for extended periods of time. Examples of short-term data may include temporary files, data being used locally by applications (which may have been copied from other storage locations), and the like.

Processor 110 and memory 115 may support an operating system under which various applications may be running. These applications may issue requests (which may be termed commands) to read data from or write data to either memory 115 or storage device 120. When storage device 120 is used to support applications reading or writing data via some sort of file system, storage device 120 may be accessed using device driver 130. While FIG. 1 shows one storage device 120, there may be any number (one or more) of storage devices in machine 105. Storage device 120 may support any desired protocol or protocols, including, for example, the Non-Volatile Memory Express (NVMe^{®}) protocol, a Serial Attached Small Computer System Interface (SCSI) (SAS) protocol, or a Serial AT Attachment (SATA) protocol. Storage device 120 may include any desired interface, including, for example, a Peripheral Component Interconnect Express (PCIe^{®}) interface, or a Compute Express Link (CXL^{®}) interface. Storage device 120 may take any desired form factor, including, for example, a U.2 form factor, a U.3 form factor, a M.2 form factor, Enterprise and Data Center Standard Form Factor (EDSFF) (including all of its varieties, such as E1 short, E1 long, and the E3 varieties), or an Add-In Card (AIC).

While FIG. 1 uses the term "storage device," embodiments of the disclosure may include any storage device formats that may benefit from the use of computational storage units, examples of which may include hard disk drives, Solid State Drives (SSDs), or persistent memory devices, such as PCM, ReRAM, or MRAM. Any reference to "storage device" "SSD" below should be understood to include such other embodiments of the disclosure and other varieties of storage devices. In some cases, the term "storage unit" may encompass storage device 120 and memory 115. Machine 105 may include power supply 135. Power supply 135 may provide power to machine 105 and its components.

Machine 105 may include transmitter 145 and receiver 150. Transmitter 145 or receiver 150 may be respectively used to transmit or receive data. In some cases, transmitter 145 and/or receiver 150 may be used to communicate with memory 115 and/or storage device 120. Transmitter 145 may include write circuit 160, which may be used to write data into storage, such as a register, in memory 115 and/or storage device 120. In a similar manner, receiver 150 may include read circuit 165, which may be used to read data from storage, such as a register, from memory 115 and/or storage device 120. In the illustrated example, machine 105 may include timer, which may be used to time one or more operations, indicate a time period, indicate a lapse of time, indicate an expiration, indicate a timeout, etc.

In one or more examples, machine 105 may be implemented with any type of apparatus. Machine 105 may be configured as (e.g., as a host of) one or more of a server such as a compute server, a storage server, storage node, a network server, a supercomputer, data center system, and/or the like, or any combination thereof. Additionally, or alternatively, machine 105 may be configured as (e.g., as a host of) one or more of a computer such as a workstation, a personal computer, a tablet, a smartphone, and/or the like, or any combination thereof. Machine 105 may be implemented with any type of apparatus that may be configured as a device including, for example, an accelerator device, a storage device, a network device, a memory expansion and/or buffer device, a central processing unit (CPU), a graphics processing unit (GPU), a neural processing unit (NPU), a tensor processing unit (TPU), optical processing units (OPU), and/or the like, or any combination thereof.

Any communication between devices including machine 105 (e.g., host, computational storage device, and/or any intermediary device) can occur over an interface that may be implemented with any type of wired and/or wireless communication medium, interface, protocol, and/or the like including PCIe, NVMe, Ethernet, NVMe-oF, Compute Express Link (CXL), and/or a coherent protocol such as CXL.mem, CXL.cache, CXL.IO and/or the like, Gen-Z, Open Coherent Accelerator Processor Interface (OpenCAPI), Cache Coherent Interconnect for Accelerators (CCIX), Advanced eXtensible Interface (AXI) and/or the like, or any combination thereof, Transmission Control Protocol/Internet Protocol (TCP/IP), FibreChannel, InfiniBand, Serial AT Attachment (SATA), Small Computer Systems Interface (SCSI), Serial Attached SCSI (SAS), Internet wide area remote direct memory access protocol (iWARP), any generation of wireless network including 2G, 3G, 4G, 5G, and/or the like, any generation of Wi-Fi, Bluetooth, near-field communication (NFC), and/or the like, or any combination thereof. In some embodiments, the communication interfaces may include a communication fabric including one or more links, buses, switches, hubs, nodes, routers, translators, repeaters, and/or the like. In some embodiments, system 100 may include one or more additional apparatus having one or more additional communication interfaces.

Any of the functionality described herein, including any of the host functionality, device functionally, and/or the like, may be implemented with hardware, software, firmware, or any combination thereof including, for example, hardware and/or software combinational logic, sequential logic, timers, counters, registers, state machines, volatile memories such as at least one of or any combination of the following: DRAM and/or SRAM, nonvolatile memory including flash memory, persistent memory such as cross-gridded nonvolatile memory, memory with bulk resistance change, PCM, and/or the like and/or any combination thereof, complex programmable logic devices (CPLDs), field programmable gate arrays (FPGAs), application specific integrated circuits (ASICs), CPUs including CISC processors such as x86 processors and/or RISC) processors such as RISC-V and/or advanced RISC machine (ARM) processors), GPUs, NPUs, TPUs, OPUs, and/or the like, executing instructions stored in any type of memory. In some embodiments, one or more components described herein may be implemented in an SoC.

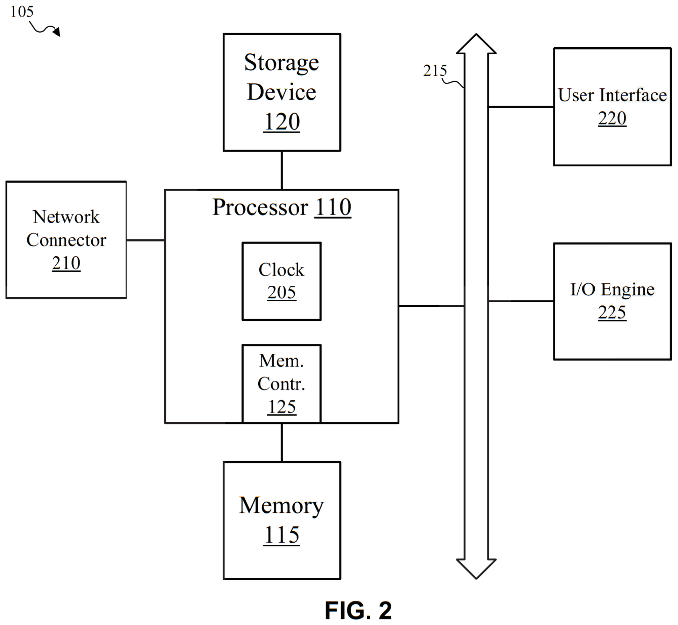

**FIG. 2** illustrates details of machine 105 of FIG. 1, according to examples described herein. In the illustrated example, machine 105 may include processor 110. Processor 110 may include one or more processors and/or one or more dies. Processor 110 may include memory controller 125 (e.g., one or more memory controllers) and clock 205 (e.g. one or more clocks), which may be used to coordinate the operations of the components of the machine. Processor 110 may be coupled to memory 115 (e.g., one or more memory chips, stacked memory, etc.), which may include random-access memory (RAM), read-only memory (ROM), or other state preserving media, as examples. Processor 110 may be coupled to storage device 120 (e.g., one or more storage devices), and to network connector 210, which may be, for example, an Ethernet connector or a wireless connector. Processor 110 may be connected to bus 215 (e.g., one or more buses), to which may be attached user interface 220 (e.g., one or more user interfaces) and Input/Output (I/O) interface ports that may be managed using I/O engine 225 (e.g., one or more I/O engines), among other components.

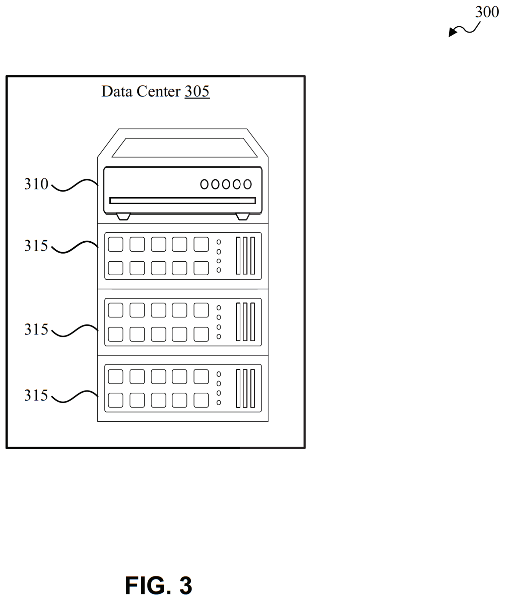

**FIG. 3** illustrates an example system 300 in accordance with one or more implementations as described herein. In the illustrated example, system 300 includes data center 305. In some embodiments, one or more data center racks 315 may be used, including any number or configuration of 2.5D and 3D stacked memory. At least one data center rack 315 may have, for example, a top of rack router 310. The top of rack router 310 may include a routing device configured to receive signaling, route processing and/or data requests to at least one data center rack 315, and the like.

At least one data center rack 315 may include any number of combination of 2.5D stacked memory (e.g., 2.5D HBM) and/or 3D stacked memory (e.g., 3D HBM). In some cases, the 2.5D stacked memory and/or the 3D stacked memory may be stacked in relation to a compute die. In some cases, the 2.5D stacked memory may be positioned adjacent to the compute die and the 3D stacked memory may be stacked on a surface of the compute die. The compute die may include at least one of a GPU, CPU, TPU, OPU, NPU, intelligence processing unit (IPU), vision processing unit (VPU), FPGA, ASIC, quantum processor, microprocessor, physics processing unit, AI accelerator, processor element, and/or host/controller device, etc. The arrangement of the 2.5D and 3D stacked memory may be in any manner, including a grid, a series, an organic arrangement, etc. The number of 2.5D and 3D HBM stacks in some embodiments may be a factor of two, for example, 8, 16, 32 or 64, or any combination allowed per die size and available space and technology.

Any of the functionality disclosed herein may be implemented with hardware, software, or a combination thereof including combinational logic, sequential logic, one or more timers, counters, registers, and/or state machines, one or more CPLDs, FPGAs, ASICs, CPUs such as CISC processors such as x86 processors and/or RISC processors such as ARM processors, GPUs, NPUs, TPUs and/or the like, executing instructions stored in any type of memory, or any combination thereof. In some embodiments, one or more components may be implemented as an SoC (e.g., AI compute SoC).

In some embodiments, storage may be separately arranged on individual data center racks 315. Any variation on amount, location and configuration of storage may be considered. Any of the storage devices disclosed herein may communicate through any interfaces and/or protocols including PCIe, NVMe, NVMe-oF, Ethernet, TCP/IP, User Datagram Protocol (UDP), remote direct memory access (RDMA), RDMA over Converged Ethernet (RoCE), FibreChannel, InfiniBand, SATA, SCSI, SAS, iWARP, hypertext transfer protocol (HTTP), HBM PHY, HBM 3D PHY, D2D, UCIe, and/or the like, or any combination thereof.

In some embodiments, one or more storage devices may be implemented with multiple storage devices arranged, for example, in one or more servers. They may be configured, for example, in one or more server chassis, server racks, groups of server racks, data rooms, datacenters, edge data centers, mobile edge datacenters, and/or the like, and/or any combination thereof. In some embodiments, data center 305 may be implemented with one or more storage server clusters.

In some examples, data center 305 may be implemented with any type and/or configuration of network resources. For example, data center 305 may include any type of network fabric such as Ethernet, Fibre Channel, InfiniBand, and/or the like, using any type of network protocols such as transmission control protocol/internet protocol (TCP/IP), RoCE, and/or the like. In some cases, data center 305 may include any type of storage interfaces and/or protocols such as SATA, SCSI, SAS, NVMe, NVMe-oF, and/or the like. In some embodiments, the data center 305 and/or at least one data center rack 315 may be implemented with one or more networks and/or network segments interconnected with one or more switches, routers, bridges, hubs, and/or the like.

The semiconductor devices described herein, may be encapsulated using various packaging techniques. For example, semiconductor devices constructed according to principles of the disclosed subject matter may be encapsulated using any one of package on package (POP) techniques, ball grid arrays (BGAs) techniques, land grid array (LGA), chip scale packages (CSPs), plastic leaded chip carrier (PLCC) techniques, plastic dual in-line package (PDIP) techniques, die in waffle pack techniques, die in wafer form techniques, chip on board (COB) techniques, ceramic dual in-line package (CERDIP) techniques, plastic metric quad flat package (PMQFP) techniques, plastic quad flat package (PQFP) techniques, small outline package (SOIC) techniques, shrink small outline package (SSOP) techniques, thin small outline package (TSOP) techniques, thin quad flat package (TQFP) techniques, system in package (SIP) techniques, multi-chip package (MCP) techniques, wafer-level fabricated package (WFP) techniques, wafer-level processed stack package (WSP) technique, and/or other technique known to those skilled in the art.

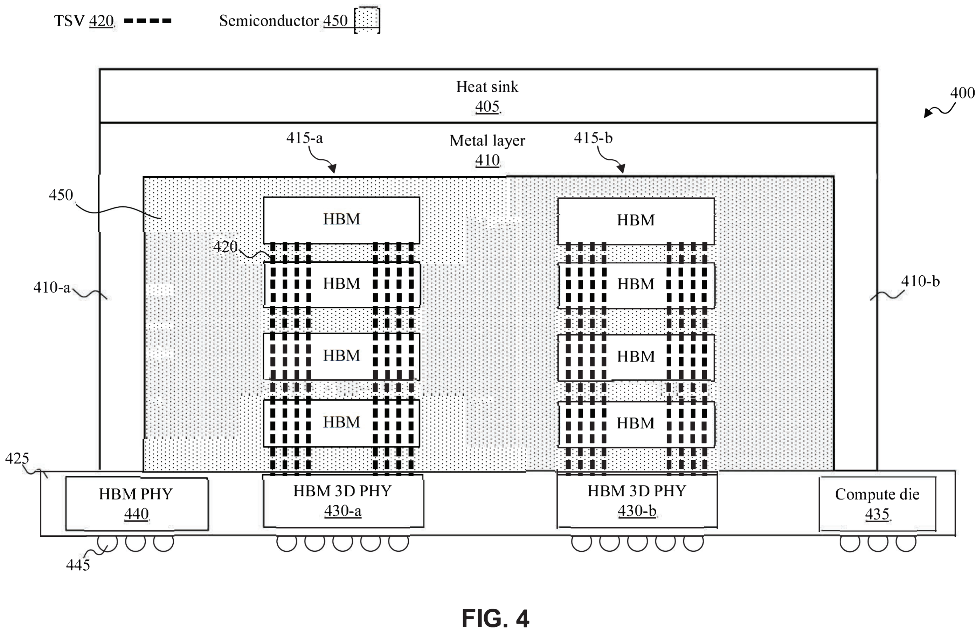

**FIG. 4** illustrates an example system 400 in accordance with one or more implementations as described herein. In some configurations, one or more aspects of system 400 may be implemented by or in conjunction with machine 105, components of machine 105, or any combination thereof. In the illustrated example, system 400 may depict aspects of a stacked memory module. Although system 400 depicts thermal TSVs in a system of HBM cubes, Applicant notes that thermal TSVs may be incorporated in any 2.5D stacking package and/or any 3D stacking package (e.g., any package that uses TSVs).

As shown, system 400 may include heat sink 405, metal layer 410, at least one memory stack (e.g., memory stack 415-a, memory stack 415-b), one or more TSVs (e.g., TSV 420), and base die 425. As depicted, base die 425 may include two or more stacked memories (e.g., HBM cubes). In some cases, a base die may include one or more multiple HBM cubes (e.g., one base die per HBM cube; two or more HBM cubes per base die, etc.). In some cases, base die 425 may include HBM 3D PHY 430-a, HBM 3D PHY 430-b, compute die 435, HBM PHY 440, and/or one or more ball grid arrays (e.g., ball grid array 445). 3D HBM PHY 430-a, 3D HBM PHY 430-b, and/or HBM PHY 440 may be based on or may incorporate a D2D interface, a UCI-e interface, etc.

In some examples, metal layer 410 may include a top metal layer positioned above each of memory stack 415-a and/or memory stack 415-b, and under heat sink 405. In some cases, metal layer 410 may include at least one metal side wall (e.g., sidewall 410-a and/or sidewall 410-b). Heat sink 405 and/or metal layer 410 may include one or more thermally conductive materials (e.g., copper, tungsten, graphite, silver, gold, aluminum, zinc, nickel, brass, bronze, iron, platinum, aluminum nitride, silicon carbide, etc.). As shown, sidewall 410-a may be adjacent to an outer surface of memory stack 415-a (e.g., a first stack of memory, a first HBM stack). In the illustrated example, sidewall 410-b may be adjacent to an outer surface of memory stack 415-b (e.g., a second stack of memory, a second HBM stack).

In some examples, memory stack 415-a may be communicatively coupled to HBM 3D PHY 430-a and/or memory stack 415-b may be communicatively coupled to HBM 3D PHY 430-b. HBM PHY 440 may be communicatively coupled to a component external to system 400 (e.g., host, machine 105, external memory, external processor, another memory module similar to system 400, etc.) As shown, memory stack 415-a and/or memory stack 415-b may be packaged in semiconductor 450 (e.g., embedded in semiconductor 450).

In some cases, semiconductor 450 (e.g., semiconductor substrate) may include silicon (e.g., dummy silicon), germanium, gallium arsenide, silicon carbide, gallium arsenic, indium arsenide, indium phosphide, and/or some other semiconductor or composite semiconductor. As shown, semiconductor 450 may be deposited over at least one of memory stack 415-a and/or memory stack 415-b. In some cases, semiconductor 450 may cover at least a portion of memory stack 415-a and/or memory stack 415-b.

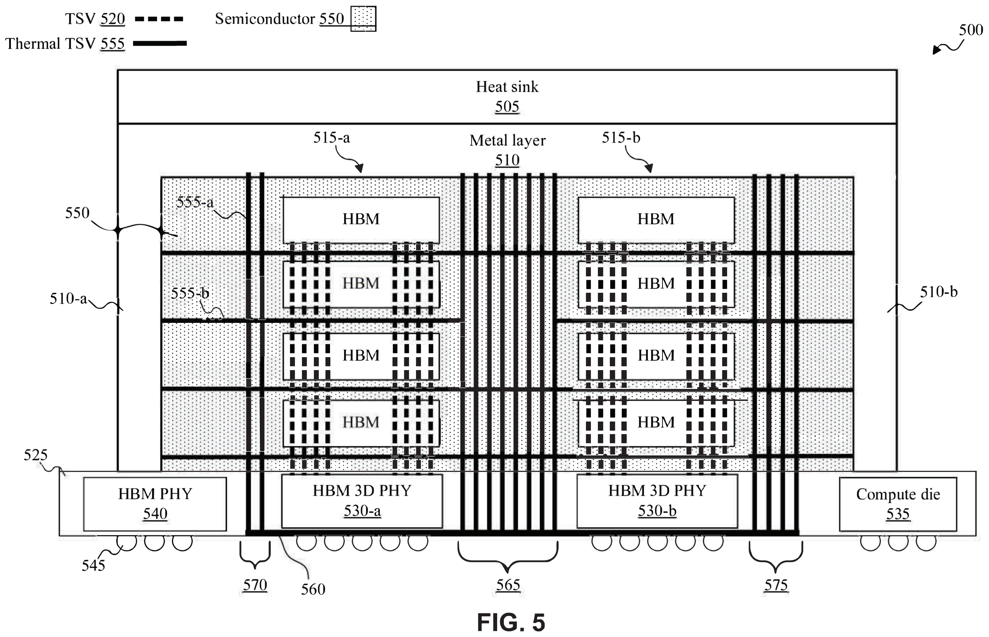

**FIG. 5** illustrates an example system 500 in accordance with one or more implementations as described herein. In some configurations, one or more aspects of system 500 may be implemented by or in conjunction with machine 105, components of machine 105, or any combination thereof.

As shown, system 500 may include heat sink 505, metal layer 510, at least one memory stack (e.g., memory stack 515-a, memory stack 515-b), one or more TSVs (e.g., TSV 520), and base die 525. As depicted, base die 525 may include two or more stacked memories (e.g., HBM cubes). As shown, memory stack 515-a or memory stack 515-b may include a stack of memory dies (e.g., a first memory die stacked on top of a 3D PHY, a second memory die stacked on top of the first memory die, etc.).

In some cases, a base die 525 may include one or more multiple HBM cubes (e.g., one base die per HBM cube; two or more HBM cubes per base die, etc.). In some cases, base die 525 may include HBM 3D PHY 530-a, HBM 3D PHY 530-b, compute die 535, HBM PHY 540, and/or one or more ball grid arrays (e.g., ball grid array 545). 3D HBM PHY 530-a, 3D HBM PHY 530-b, and/or HBM PHY 540 may be based on or may incorporate a D2D interface, a UCI-e interface, etc.

In some examples, metal layer 510 may include a top metal layer positioned above each of memory stack 515-a and/or memory stack 515-b, and under heat sink 505. In some cases, metal layer 510 may include at least one metal side wall (e.g., sidewall 510-a and/or sidewall 510-b). As depicted, system 500 may include metal layer 560 (e.g., bottom metal layer). Heat sink 505, metal layer 510, and/or metal layer 560 may include, respectively, one or more thermally conductive materials (e.g., copper, tungsten, graphite, silver, gold, aluminum, zinc, nickel, brass, bronze, iron, platinum, aluminum nitride, silicon carbide, etc.). As shown, sidewall 510-a may be adjacent to an outer surface of memory stack 515-a (e.g., a first stack of memory, a first HBM stack). In the illustrated example, sidewall 510-b may be adjacent to an outer surface of memory stack 515-b (e.g., a second stack of memory, a second HBM stack). Metal layer 560 may be located in or adjacent to base die 525. In some cases, metal layer 560 may be deposited below HBM 3D PHY 530-a and/or HBM 3D PHY 530-b.

In some examples, memory stack 515-a may be communicatively coupled to HBM 3D PHY 530-a and/or memory stack 515-b may be communicatively coupled to HBM 3D PHY 530-b. HBM PHY 540 may be communicatively coupled to a component external to system 500 (e.g., host, machine 105, external memory, external processor, another memory module similar to system 500, etc.) As shown, memory stack 515-a and/or memory stack 515-b may be packaged in semiconductor 550 (e.g., embedded in semiconductor 550).

In some cases, semiconductor 550 (e.g., semiconductor substrate) may include silicon (e.g., dummy silicon), germanium, gallium arsenide, silicon carbide, gallium arsenic, indium arsenide, indium phosphide, and/or some other semiconductor or composite semiconductor. As shown, semiconductor 550 may be deposited over at least one of memory stack 515-a and/or memory stack 515-b. In some cases, semiconductor 550 may cover (e.g., be deposited over) at least a portion of memory stack 515-a and/or memory stack 515-b.

To resolve thermal issue due to stacking semiconductor chips (e.g., HBM 3D-stacking), the systems and methods may include implementing dedicated thermal dissipation through silicon via (TSV) lines (e.g., thermal TSVs). In some cases, thermal TSVs may be added to a dummy silicon area to increase thermal dissipation of semiconductor dies. In some embodiments, an end of a thermal TSV line may be in contact with a metal layer (e.g., conductive metal layer, top metal layer, bottom metal layer, side metal layer) of a compute die. The dummy metal layer may act like a heat spreader in lateral direction. The dummy metal pattern may be formed by using an unused area in the top metal layer, so that it may connect to a thermal TSV.

As shown, system 500 may include one or more thermal TSVs (e.g., thermal TSVs 555). In some cases, at least one thermal TSV may be routed through semiconductor 550. Thermal TSVs 555 may include at least one vertical thermal TSV (e.g., TSV 555-a). As shown, at least one vertical thermal TSV may be routed from a bottom metal layer (e.g., metal layer 560) to a top metal layer (e.g., metal layer 510). For example, at least one vertical thermal TSV may connect to the bottom metal layer and/or connect to the top metal layer, enabling the at least one vertical thermal TSV to transfer thermal energy to the bottom metal layer and/or to the top metal layer (e.g., and from a top metal layer of metal layer 510 to head sink 505).

In the depicted example, thermal TSVs 555 may include at least a central portion 565 of one or more thermal TSVs, a first outer portion 570 of one or more thermal TSVs, and/or a second outer portion 575 of one or more thermal TSVs. At least one vertical thermal TSV (e.g., of first outer portion 570) may be routed between a first metal sidewall (e.g., sidewall 510-a) and a first 3D memory stack (e.g., memory stack 515-a, adjacent to an outer surface of memory stack 515-a). In some examples, at least one vertical thermal TSV (e.g., of second outer portion 570) may be routed between a first PHY of base die 525 (e.g., HBM PHY 540) and a second PHY of base die 525 (e.g., HBM 3D PHY 530-b).

At least one vertical thermal TSV (e.g., of central portion 565) may be routed between the first 3D memory stack (e.g., memory stack 515-a, adjacent to an inner surface of memory stack 515-a) and a second 3D memory stack (e.g., memory stack 515-b, adjacent to an inner surface of memory stack 515-b). For example, at least one vertical thermal TSV may be routed between a first 3D PHY (e.g., HBM 3D PHY 530-a) and a second 3D PHY (e.g., HBM 3D PHY 530-b).

In some cases, at least one vertical thermal TSV (e.g., of second outer portion 575) may be routed between the second 3D memory stack (e.g., memory stack 515-b, adjacent to an outer surface of memory stack 515-b) and a second metal sidewall (e.g., sidewall 510-b). For example, at least one vertical thermal TSV may be routed between a 3D PHY (e.g., HBM 3D PHY 530-b) and a compute die (e.g., compute die 535).

In the depicted example, thermal TSVs 555 may include at least one horizontal thermal TSV (e.g., TSV 555-b). As shown, at least one horizontal thermal TSV may be routed between a 3D PHY (e.g., HBM 3D PHY 530-a and/or HBM 3D PHY 530-b) and a memory die

(e.g., a memory die of memory stack 515-a and/or a memory die of memory stack 515-b). In some cases, at least one horizontal thermal TSV may be routed from a first metal sidewall (e.g., sidewall 510-a) to a second metal sidewall (e.g., sidewall 510-b). In some cases, at least one horizontal thermal TSV may connect to at least one metal sidewall, enabling the at least one horizontal thermal TSV to transfer thermal energy to the at least one metal sidewall (e.g., to sidewall 510-a and/or to sidewall 510-b).

In some examples, at least one horizontal thermal TSV (e.g., TSV 555-b) may intersect at least one vertical thermal TSV (e.g., TSV 555-a). In some cases, at least one vertical thermal TSV may be routed past at least one horizontal thermal TSV without the at least one vertical thermal TSV physically connecting to the at least one horizontal thermal TSV. In some cases, at least one horizontal thermal TSV (e.g., TSV 555-b) may initiate with a connection to sidewall 510-a, pass between two memory dies of memory stack 515-a, and terminate within or near a region of central portion 565. In some cases, the at least one horizontal thermal TSV may terminate within or near a region of central portion 565 and physically connect to at least one vertical thermal TSV of central portion 565, or terminate within or near a region of central portion 565 without physically connecting to a vertical thermal TSV.

Although the depiction of system 500 shows semiconductor 550 between memory dies of memory stack 515-a and memory stack 515-b, in some cases, relatively little to no semiconductor may be deposited between one or more pairs of memory dies of memory stack 515-a and/or memory stack 515-b. Although the illustrated example, depicts system 500 including stacked memory dies, additionally, or alternatively, system 500 may include stacks of other types of semiconductor chips or integrated circuit (IC) dies (e.g., logic dies, processing dies, and/or memory dies, etc.). In some embodiments, thermal TSVs may be implemented to multiple 3D packages (e.g., multiple compute die 3D packages and/or multiple memory dies 3D packages, etc.).

Accordingly, based at least in part on the features of system 500 and/or methods associated with system 500, the systems and methods described herein may be based on at least one of: connecting an end or termination of a thermal TSV line to a metal layer (e.g., bottom metal layer) to dissipate heat from a bottom metal layer to a top metal layer (e.g., towards a heat sink); connecting an end or termination of a thermal TSV line to a top metal layer of a compute die; connecting an end or termination of a thermal TSV line to a side metal layer of a compute die to dissipate heat; a dummy metal layer (e.g., metal layer 510, metal layer 560) spreading heat in a lateral direction; connecting thermal TSVs to at least a portion of the dummy metal layer (e.g., using an unused area in a top metal layer); implementing thermal TSVs for HBM 3D stacking and/or general 3D stacking packages that use TSVs; implementing additional thermal TSVs in between HBM dies to increase thermal dissipation of each HBM layer in the lateral direction.

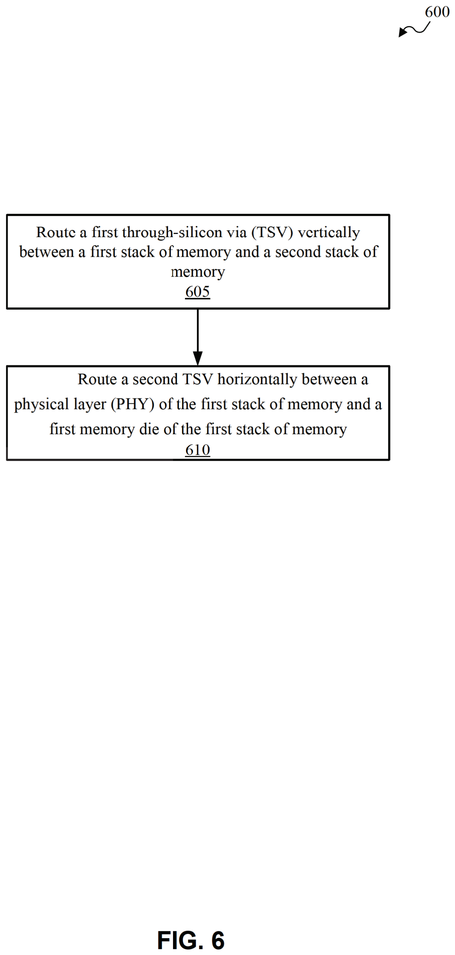

**FIG. 6** depicts a flow diagram illustrating an example method 600 associated with the disclosed systems, in accordance with example implementations described herein. In some configurations, one or more aspects of method 600 may be implemented by or in conjunction with machine 105, components of machine 105, or any combination thereof. The depicted method 600 is just one implementation and one or more operations of method 600 may be rearranged, reordered, omitted, and/or otherwise modified such that other implementations are possible and contemplated.

At 605, method 600 may include routing a first through-silicon via (TSV) vertically between a first stack of memory and a second stack of memory. For example, a first TSV may be routed vertically between a first stack of memory (e.g., memory stack 515-a) and a second stack of memory (e.g., memory stack 515-b). In some cases, the first TSV may be connected to at least one of a base metal layer (e.g., metal layer 560) and/or a top metal layer (e.g., metal layer 510).

At 610, method 600 may include routing a second TSV horizontally between a physical layer (PHY) of the first stack of memory and a first memory die of the first stack of memory. For example, a second TSV may be routed horizontally between at least one of: a physical layer (PHY) of the first stack of memory and a first memory die of the first stack of memory, or a PHY of the second stack of memory and a first memory die of the second stack of memory. In some cases, the second TSV may be connected to at least one of a metal sidewall (e.g., sidewall 510-a) and/or a second metal sidewall (e.g., sidewall 510-b).

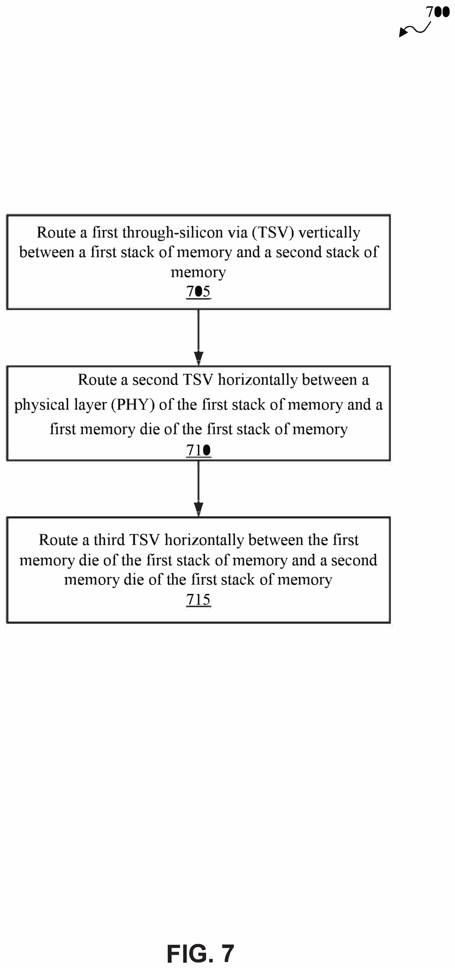

**FIG. 7** depicts a flow diagram illustrating an example method 700 associated with the disclosed systems, in accordance with example implementations described herein. In some configurations, one or more aspects of method 700 may be implemented by or in conjunction with machine 105, components of machine 105, or any combination thereof. The depicted method 700 is just one implementation and one or more operations of method 700 may be rearranged, reordered, omitted, and/or otherwise modified such that other implementations are possible and contemplated.

At 705, method 700 may include routing a first through-silicon via (TSV) vertically between a first stack of memory and a second stack of memory. For example, a first TSV may be routed vertically between a first stack of memory (e.g., memory stack 515-a) and a second stack of memory (e.g., memory stack 515-b). In some cases, the first TSV may be connected to at least one of a base metal layer (e.g., metal layer 560) and/or a top metal layer (e.g., metal layer 510).

At 710, method 700 may include routing a second TSV horizontally between a physical layer (PHY) of the first stack of memory and a first memory die of the first stack of memory. For example, a second TSV may be routed horizontally between at least one of: a physical layer (PHY) of the first stack of memory and a first memory die of the first stack of memory, or a PHY of the second stack of memory and a first memory die of the second stack of memory. In some cases, the second TSV may be connected to at least one of a metal sidewall (e.g., sidewall 510-a) and/or a second metal sidewall (e.g., sidewall 510-b).

At 715, method 700 may include routing a third TSV horizontally between the first memory die of the first stack of memory and a second memory die of the first stack of memory. For example, a third TSV may be routed horizontally between at least one of: the first memory die of the first stack of memory and a second memory die of the first stack of memory and/or the first memory die of the second stack of memory and a second memory die of the second stack of memory.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" is used herein to mean "serving as an example, instance, or illustration." Any embodiment described herein as "exemplary" is not necessarily to be construed as preferred or advantageous over other embodiments. The terms "computing device," "user device ," "communication station," "station," "handheld device," "mobile device," "wireless device" and "user equipment" (UE) as used herein refers to a wired and/or wireless communication device such as a switch, router, network interface controller, cellular telephone, smartphone, tablet, netbook, wireless terminal, laptop computer, a femtocell, High Data Rate (HDR) subscriber station, access point, printer, point of sale device, access terminal, or other personal communication system (PCS) device. The device may be wireless, wired, mobile, and/or stationary.

As used within this document, the term "communicate" is intended to include transmitting, or receiving, or both transmitting and receiving. Similarly, the bidirectional exchange of data between two devices (both devices transmit and receive during the exchange) may be described as 'communicating', when only the functionality of one of those devices is being claimed. The term "communicating" as used herein with respect to wired and/or wireless communication signals includes transmitting the wired and/or wireless communication signals and/or receiving the wired and/or wireless communication signals. For example, a communication unit, which is capable of communicating wired and/or wireless communication signals, may include a wired/wireless transmitter to transmit communication signals to at least one other communication unit, and/or a wired/wireless communication receiver to receive the communication signal from at least one other communication unit.

Some embodiments may be used in conjunction with various devices and systems, for example, a Personal Computer (PC), a desktop computer, a mobile computer, a laptop computer, a notebook computer, a tablet computer, a server computer, a handheld computer, a handheld device, a Personal Digital Assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless Access Point (AP), a wired or wireless router, a wired or wireless modem, a video device, an audio device, an audio-video (A/V) device, a wired or wireless network, a wireless area network, a Wireless Video Area Network (WVAN), a Local Area Network (LAN), a Wireless LAN (WLAN), a Personal Area Network (PAN), a Wireless PAN (WPAN), and the like.

Some embodiments may be used in conjunction with one way and/or two-way radio communication systems, cellular radio-telephone communication systems, a mobile phone, a cellular telephone, a wireless telephone, a Personal Communication Systems (PCS) device, a PDA device which incorporates a wireless communication device, a mobile or portable Global Positioning System (GPS) device, a device which incorporates a GPS receiver or transceiver or chip, a device which incorporates an RFID element or chip, a Multiple Input Multiple Output (MIMO) transceiver or device, a Single Input Multiple Output (SIMO) transceiver or device, a Multiple Input Single Output (MISO) transceiver or device, a device having one or more internal antennas and/or external antennas, Digital Video Broadcast (DVB) devices or systems, multistandard radio devices or systems, a wired or wireless handheld device, e.g., a Smartphone, a Wireless Application Protocol (WAP) device, or the like.

Some embodiments may be used in conjunction with one or more types of wireless communication signals and/or systems following one or more wireless communication protocols, for example, Radio Frequency (RF), Infrared (IR), Frequency-Division Multiplexing (FDM), Orthogonal FDM (OFDM), Time-Division Multiplexing (TDM), Time-Division Multiple Access (TDMA), Extended TDMA (E-TDMA), General Packet Radio Service (GPRS), extended GPRS, Code-Division Multiple Access (CDMA), Wideband CDMA (WCDMA), CDMA 2000, single-carrier CDMA, multi-carrier CDMA, Multi-Carrier Modulation (MDM), Discrete Multi-Tone (DMT), Bluetooth^{™}, Global Positioning System (GPS), Wi-Fi, Wi-Max, ZigBee^{™}, Ultra-Wideband (UWB), Global System for Mobile communication (GSM), 2G, 2.5G, 3G, 3.5G, 4G, Fifth Generation (5G) mobile networks, 3GPP, Long Term Evolution (LTE), LTE advanced, Enhanced Data rates for GSM Evolution (EDGE), or the like. Other embodiments may be used in various other devices, systems, and/or networks.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example an FPGA (field programmable gate array) or an ASIC (application-specific integrated circuit). The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random-access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, for example a CRT (cathode ray tube) or LCD (liquid crystal display) monitor, for displaying information/data to the user and a keyboard and a pointing device, for example a mouse or a trackball, by which the user can provide input to the computer. Other kinds of devices can be used to provide for interaction with a user as well; for example, feedback provided to the user can be any form of sensory feedback, for example visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, for example as an information/data server, or that includes a middleware component, for example an application server, or that includes a front-end component, for example a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example an HTML page) to a client device (for example for purposes of displaying information/data to and receiving user input from a user interacting with the client device). Information/data generated at the client device (for example a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

Many modifications and other examples as set forth herein will come to mind to one skilled in the art to which these embodiments pertain having the benefit of the teachings presented in the foregoing descriptions and the associated drawings. Therefore, it is to be understood that the embodiments are not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A stacked integrated circuit, IC, device (500) comprising:
a first through-silicon via, TSV, (555-a) for heat dissipation routed vertically adjacent to at least one of a first stack of dies (515-a) or a second stack of dies (515-b); and
a second TSV (555-b) for heat dissipation routed horizontally between at least one of:
a physical layer, PHY, (530-a) of the first stack of dies (515-a) and a first IC die of the first stack of dies (515-a), or
a PHY of the second stack of dies (515-b) and a first IC die of the second stack of dies (515-b).

2. The stacked IC device (500) of claim 1, wherein the first TSV (555-a) connects to a first metal layer (510) positioned above the first stack of dies (515-a) and the second stack of dies (515-b).

3. The stacked IC device (500) of claim 2, wherein a heat sink (505) is positioned on a top surface of the first metal layer.

4. The stacked IC device (500) of any one of claims 1 to 3, wherein the first TSV (555-a) connects to a second metal layer (560) below the first stack of dies (515-a) and the second stack of dies (515-b).

5. The stacked IC device (500) of claim 4, wherein the second metal layer (560) is below at least one of the PHY of the first stack of dies (515-a) or the PHY of the second stack of dies (515-b).

6. The stacked IC device (500) of any one of claims 1 to 5, wherein the second TSV (555-b) connects to at least one of a first metal sidewall adjacent to an outer surface of the first stack of dies (515-a) or a second metal sidewall adjacent to an outer surface of the second stack of dies (515-b).

7. The stacked IC device (500) of any one of claims 1 to 6, wherein at least one of the first TSV (555-a) or the second TSV (555-b) is routed through a semiconductor that is deposited over at least one of the first stack of dies or the second stack of dies.

8. The stacked IC device (500) of any one of claims 1 to 7, wherein the second TSV (555-b) connects to the first TSV (555-a).

9. The stacked IC device (500) of any one of claims 1 to 8, further comprising a third TSV routed horizontally between at least one of:
the first IC die of the first stack of dies (515-a) and a second IC die of the first stack of dies (515-a), or
the first IC die of the second stack of dies (515-b) and a second IC die of the second stack of dies (515-b).

10. The stacked IC device (500) of any one of claims 1 to 8, wherein:
the first stack of dies (515-a) is a first stack of memory,
the second stack of dies (515-b) is a second stack of memory,
the first IC die of the first stack of dies (515-a) is a first memory die of the first stack of memory, and
the first IC die of the second stack of dies (515-b) is a first memory die of the second stack of memory.

11. The stacked IC device (500) of claim 10, further comprising a third TSV routed horizontally between at least one of:
the first memory die of the first stack of memory and a second memory die of the first stack of memory, or
the first memory die of the second stack of memory and a second memory die of the second stack of memory.

12. A method of thermal dissipation, the method comprising:
routing (605, 705), for heat dissipation, a first through-silicon via, TSV, (555-a) vertically adjacent to at least one of a first stack of memory (515-a) or a second stack of memory (515-b); and
routing (610, 710), for heat dissipation, a second TSV (555-b) horizontally between at least one of:
a physical layer (PHY) of the first stack of memory (515-a) and a first memory die of the first stack of memory (515-a), or
a PHY of the second stack of memory (515-b) and a first memory die of the second stack of memory (515-b).

13. The method of claim 12, further comprising routing (715) a third TSV horizontally between at least one of:
the first memory die of the first stack of memory (515-a) and a second memory die of the first stack of memory (515-a), or
the first memory die of the second stack of memory (515-b) and a second memory die of the second stack of memory (515-b).

14. The method of claim 12 or 13, wherein the first TSV (555-a) connects to a first metal layer (510) positioned above each of the first stack of memory (515-a) and the second stack of memory (515-b).
